# EUROPEAN PATENT SPECIFICATION

(11) **EP 1 785 807 B1**
(45) Date of publication and mention of the grant of the patent: **18.03.2009**
(21) Application number: 05024631.3
(22) Date of filing: 11.11.2005
(51) Int. Cl.: G06F 1/20, H04N 5/77, G06K 19/077, H05K 5/02, H05K 7/20

(54) **Cooling of a small electronic device with a USB connector**
Kühlung von einem kleinen elektronischen Gerät mit einem USB Verbinder.
Refroidissement d'un petit appareil électronique avec un connecteur USB.

(43) Date of publication of application: 16.05.2007
(73) Proprietor: Lite-On Technology Corporation, Neihu Dis Taipei 114 (TW)
(72) Inventor: Wang, Chen-Hsing, Sinjhuang City Taipei County (TW); Chen, Ching-Hui, Hsintie City Taipei (TW)
(74) Representative: TER MEER - STEINMEISTER & PARTNER GbR

(56) References cited:
- US-A- 5 659 459
- US-A1- 2004 008 502
- US-A1- 2005 024 526
- US-A1- 2005 088 827
- US-B1- 6 781 846

## Description

The invention generally relates to a portable electronic device and in particular to a portable digital video broadcasting (DVB) electronic device.

The unceasing technology developments gradually change people's lives. In accordance to such development tendency, many merchants research and develop kinds of portable electronic devices. For example, as a result of digital television development, watching television is unlimited to a fixed location as long as a digital video receiver is being used. A notebook computer may become a portable television when a user links a digital video receiver to the notebook computer, and uses the digital video receiver to receive signals of television channels.

At the present market, some digital television boxes can meet the carrying needs for most people. However, designs to be light, thin, short and small are always the goals of research and development in electronic products. The objectives of light, thin, short and small mainly include aspects of electronic design and mechanical design. The development of the present integrated circuit technology is capable of reducing the scales of electric circuits. However, a suitable dissipation mechanism is still strongly needed to dissipate the heat generated by the chips on the Integrate Circuits (ICs) during operation.

The known digital television box has a larger volume so as to mount a ventilation fan therein to dissipate the heat of the chip. However, when the size of processor chip is reduced without difficulty, a heat dissipating fan is unable to be installed in the small space. Without suitable heat dissipation mechanism, the heat of the chip will accumulate and cause an overheat problem. In conventional heat dissipating method, a metal case is often utilized to improve the heat dissipation. However, since the generated heat is directly transmitted to the metal case of the electronic device, it leads to a safe concern due to the massive heat generated by the ICs of the electronic device. For example, in a television box, the operation temperature of processor chips may reach 80 or 90 centigrade degrees. Thus, a user may get hurt if carelessly touches it. Under the design goals of light, thin, short and small, how to carry out heat dissipation safely and effectively is the key point of miniaturization of electronic products.

US 5,659,459 is concerned with a cartridge for electronic devices including grounding pads and conductive shielding to decrease the wavelength of emitted radio magnetic radiation. The cartridge comprises a housing with vents provided at the backside thereof. A circuit board is disposed in the housing and provided with a microprocessor chip. A heat dissipating plate is mounted on a lower case of the housing so that it covers the top of the microprocessor chip. The heat generated by the microprocessor is dissipated via a heat dissipating material to the heat dissipating plate so that the heat can be dissipated to the vents at the backside of the housing and by heat conduction efficiently to the lower case where it is further dissipated to the surrounding environment.

US 2005 / 088827 is concerned with an electrical card having a heatsink device. The electrical card comprises an upper cover, a lower cover connected to the upper cover by means of a plastic frame, a printed circuit board with heat generating elements installed thereon, and a heatsink device having a base plate, and a plurality of heatsink fins thereon. The heatsink device is mounted on the printed circuit board in contact with the heat generating elements in the original cavity between the upper and lower cover.

US 6,781,846 B1 describes an IC card and an IC card cooling tray, the IC-card having a housing with openings through the wall of the card housing, a printed wiring board, a connector, electronic components, and a plate like metal block. Heat generated by the electronic components is transferred through the metal plate of the metal wiring board and the metal block to the card housing with high efficiency, thereby approving the heat radiation efficiency.

### SUMMARY OF THE INVENTION

The present electronic products, besides the function demands, are also required to be light, thin, short and small as major goals. In the miniaturized process, the heat dissipation is a major problem. Therefore, the invention provides a high-efficient heat dissipation structure for a portable electronic device.

An electronic device structure according to the invention includes a housing, a circuit board, at least a processor chip a USB interface connector, and a heatsink. The processor chip is mounted on the circuit board and generates heat during operation. The heatsink is mounted on and contacted with the processor chip. The processor chip, the circuit board and the heatsink are disposed in the housing. A side panel with a plurality of vents is mounted on a side of the housing. When the processor chip operates, the generated heat is conducted to the heatsink and dissipated via the air coming through the vents of the housing. The heat is dispersed outside via the vents and the operating temperature of the processor chip is effectively reduced.

The electronic device structure according to the invention dissipates the heat of the processor chip during operation and prevents the heat from directly conducting to the housing. The heat is dispersed outside via the vents on the housing so as to avoid user getting hurt from high temperature surface of the housing. It becomes a good solution of dissipation of portable electronic device.

### BRIEF DESCRIPTION OF THE DRAWINGS

The present invention will become more fully understood from the detailed description given hereinbelow illustration only, and thus are not limitative of the present invention, and wherein:
FIG. 1 is an exploded view of a first embodiment of the invention;
FIG. 2 is a perspective view of a first embodiment of the invention;
FIG. 3 is a sectional view of a first embodiment of the invention;
FIG. 4 is a sectional view of a second embodiment of the invention;
FIG. 5 is a sectional view of a third embodiment of the invention;
FIG. 6 is a sectional view of a fourth embodiment of the invention; and
FIG. 7 is a sectional view of a fifth embodiment of the invention.

### DETAILED DESCRIPTION OF THE INVENTION

The structure of electronic device according to the invention is mainly applicable to portable electronic devices. The portable electronic devices are digital video broadcasting (DVB) devices, MPEG player 3 (MP3) music players and so on. In the following detailed description of preferred embodiments of the invention, digital signal processors are taken as examples.

### FIRST EMBODIMENT

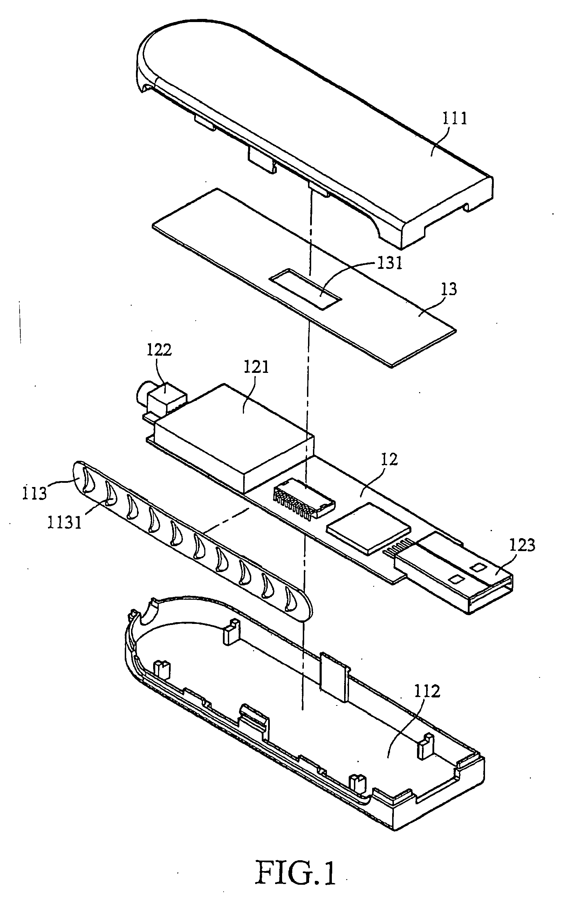

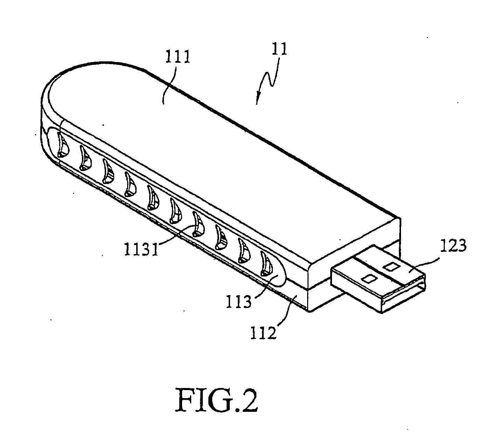

As shown in FIGS. 1 and 2, an electronic device of the invention includes a housing 11, a circuit board 12 and a heatsink 13. The housing 11 is composed of an upper case 111, a lower case 112 and a side panel 113. The upper case 111, the lower case 112 and the side panel 113 are assembled to form a containing space. Several vents 1131 of via holes are formed on the side panel 113.

The circuit board 12 has a plurality of electronic components mounted thereon for performing preset functions. The circuit board 12 includes at least a processor chip 121. In this embodiment, the processor chip 121 is a digital video broadcasting (DVB) chip that receives digital video signal through an antenna 122, processes the signal and transfers it to a computer (not shown) via a connector 123 for a user to view the video broadcasting programs through the computer. The heatsink 13 is a metal plate with a high thermal conductivity. In addition, the heatsink 13 can further comprise at least one cutoff 13 according to product requirements.

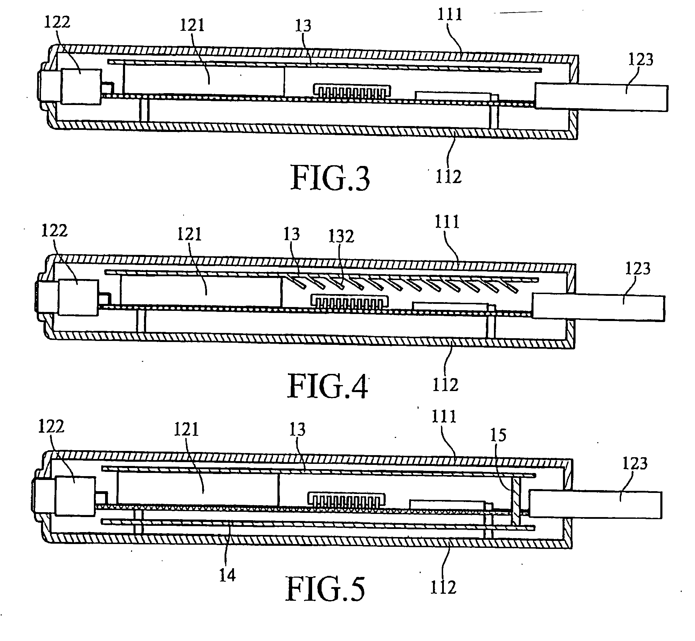

Further referring to FIG. 3, a sectional view of the invention, the circuit board 12 is installed inside the housing 11. The heatsink 13 is closely mounted on top of the processor chip 121. The cutoff 131 on the heatsink 13 is for some components on the circuit board 12 to pass through. In order to provide good thermal conduction, a suitable thermal conductive sealant (not shown in the drawing) can be applied between the processor chip 121 and the heatsink 13. The connector 123 in the embodiment of the invention is a Universal Serial Bus (USB) interface connector that can provide electric power to the electronic device. The processor chip 121 receives digital video signals via the antenna 122 and processes the signals. The heat generated during the operation is conducted to the heatsink 13 and dissipated by the air coming through the vents 1131 on the side panel 113 of the housing 11. The cool air comes through the vents 1131 to the interior of the housing 11 cools down the temperature of the processor chip 121 via the heatsink 13. Since the heat of the processor 121 is not directly conducted to the housing 11, it prevents the housing 11 from high temperature and will not hurt the user.

### SECOND EMBODIMENT

As shown in FIG. 4, a second embodiment of the invention, the heatsink 13 further comprises a plurality of fins 132 at positions where they won't interfere with the electronic components of the circuit board 12 so as to improve heat dissipation efficiency.

### THIRD EMBODIMENT

As shown in FIG. 5, a third embodiment of the invention, a second heatsink 14 is further located under the circuit board 12 and relatively to the processor chip 121. A thermal conductive element 15 links the first and the second heatsinks 13 and 14 so that heat of the first heatsink 13 is conducted to the second heatsink 14. The expanded area of the heatsinks 13 and 14 helps temperature reduction of the processor chip 121.

### FOURTH EMBODIMENT

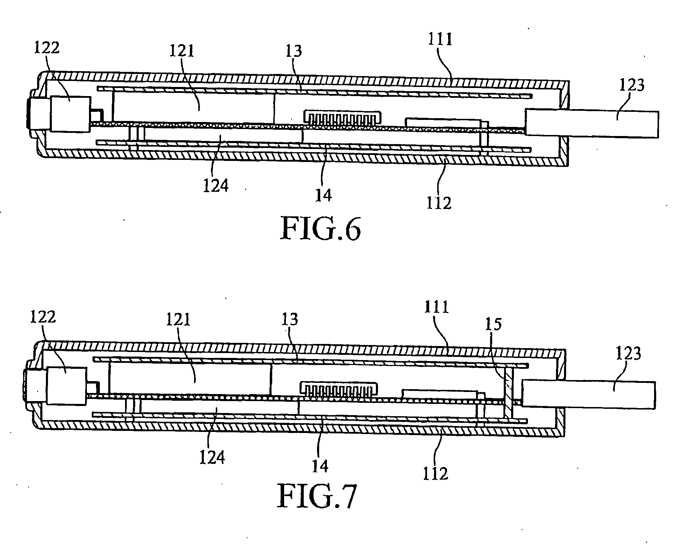

As shown in FIG. 6, a fourth embodiment of the invention, the circuit board 12 is a double-face circuit board that the other side of the circuit board includes at least a second processor chip 124 so as to reduce the dimension of the whole circuit board 12. The second processor chip 124 is connected with a second heatsink 14 so that the heat generated by the second processor chip 124 and conducted to the second heatsink 14 is dissipated by the air coming via the vents 1131 on the side panel 113 of the case 11. The second heatsink 14 helps temperature reduction of the second processor chip 124 and prevents the heat from directly conducting to the lower case 112.

### FIFTH EMBODIMENT

As shown in FIG. 7, a fifth embodiment of the invention, the circuit board 12 is a double-face circuit board that a processor chip 121 contacted with a first heatsink 13 is mounted on the upper side of the board 12, and a second processor chip 124 contacted with a second heatsink 14 is mounted on the lower side of the board 12. A thermal conductive element 15 links the first and the second heatsinks 13 and 14 so that any temperature difference caused by different operation frequencies of the chips 121, 124 is conducted between the first heatsink 13 and the second heatsink 14 so as to improve the whole efficiency of heat dissipation.

## Claims

1. A portable digital video broadcasting (DVB) electronic device comprising:
- a housing (11) having a plurality of vents (1131);
- a circuit board (12) installed inside the housing and having a DVB chip (121) generating heat during processing and a plurality of electronic components for achieving preset functions;
- a USB interface connector (123), exposed to the housing (11) and electrically connected to the circuit board (12); and
- a first heatsink (13), disposed inside the housing (11) and closely mounted on the top of the DVB chip (121) so as to dissipate the heat from the DVB chip (121) through the vents (1131) and to prevent the heat from directly conducting to the housing.

2. The portable DVB electronic device according to claim 1, wherein the housing (11) comprises an upper case (111), a lower case (112) and at least a side panel (113), the side panel (113) having the vents (1131) and connecting the upper case (111) and the lower case (112).

3. The portable DVB electronic device according to claim 1 wherein the first heatsink (13) comprises a plurality of fins (132) to dissipating the heat.

4. The portable DVB electronic device according to claim 1 wherein the first heatsink (13) comprises at least one cutoff (131) conforming to outline requirements of the circuit board (12).

5. The portable DVB electronic device according to claim 1 further comprising:
- a processor chip (124) mounted on bottom side of the circuit board (12) and generating heat; and
- a second heatsink (14) connected to the processor chip (124) for dissipating the heat generated by the processor chip (124) through the vents (1131) thus preventing the heat from directly conducting to the housing.

6. The portable DVB electronic device according to claim 5, further comprising a thermal conductive element (15) disposed between the first heatsink (13) and the second heatsink (14) to dissipating the heat from the first and second heatsinks (13, 14).

7. The portable DVB electronic device according to claim 1, further comprising
- a second heatsink (14) located under the circuit board; and
- a thermal conductive element (15) disposed between the first heatsink (13) and the second heatsink (14) to dissipating the heat from the first and second heatsinks (13, 14).

## Patentansprüche

1. Tragbare elektronische Vorrichtung für digitales Fernsehen (DVB-Vorrichtung), die umfasst:
- ein Gehäuse (11) mit mehreren Lüftungsöffnungen (1131);
- eine Leiterplatte (12), die in dem Gehäuse installiert ist und einen DVB-Chip (121), der während der Verarbeitung Wärme erzeugt, sowie mehrere elektronische Komponenten für die Ausführung von im Voraus festgelegten Funktionen aufweist;
- einen USB-Schnittstellenverbinder (123), der von außerhalb des Gehäuses (11) zugänglich ist und mit der Leiterplatte (12) elektrisch verbunden ist; und
- einen ersten Kühlkörper (13), der sich im Gehäuse (11) befindet und nahe an der Oberseite des DVB-Chips (121) montiert ist, um die Wärme vom DVB-Chip (121) durch die Lüftungsöffnungen (1131) abzuführen und um zu verhindern, dass Wärme direkt zum Gehäuse geleitet wird.

2. Tragbare elektronische DVB-Vorrichtung nach Anspruch 1, wobei das Gehäuse (11) ein oberes Gehäuseteil (111), ein unteres Gehäuseteil (112) und wenigstens eine Seitenplatte (113) umfasst, wobei die Seitenplatte (113) die Lüftungsöffnungen (1131) aufweist und das obere Gehäuseteil (111) mit dem unteren Gehäuseteil (112) verbindet.

3. Tragbare elektronische DVB-Vorrichtung nach Anspruch 1, wobei der erste Kühlkörper (13) mehrere Kühlrippen (132) umfasst, um Wärme abzuführen.

4. Tragbare elektronische DVB-Vorrichtung nach Anspruch 1, wobei der erste Kühlkörper (13) wenigstens einen Ausschnitt (131) aufweist, der an die Umrissanforderungen der Leiterplatte (12) angepasst ist.

5. Tragbare elektronische DVB-Vorrichtung nach Anspruch 1, die ferner umfasst:
- einen Prozessorchip (124), der an der Unterseite der Leiterplatte (12) montiert ist und Wärme erzeugt; und
- einen zweiten Kühlkörper (14), der mit dem Prozessorchip (124) verbunden ist, um die durch den Prozessorchip (124) erzeugte Wärme durch die Lüftungsöffnungen (1131) abzuführen und um so zu verhindern, dass Wärme direkt zum Gehäuse weitergeleitet wird.

6. Tragbare elektronische DVB-Vorrichtung nach Anspruch 5, die ferner ein wärmeleitendes Element (15) umfasst, die zwischen dem ersten Kühlkörper (13) und dem zweiten Kühlkörper (14) angeordnet ist, um die Wärme von dem ersten und von dem zweiten Kühlkörper (13, 14) abzuführen.

7. Tragbare elektronische DVB-Vorrichtung nach Anspruch 1, die ferner umfasst:
- einen zweiten Kühlkörper (14), der sich unter der Leiterplatte befindet; und
- ein wärmeleitendes Element (15), das zwischen dem ersten Kühlkörper (13) und dem zweiten Kühlkörper (14) angeordnet ist, um die Wärme von dem ersten und dem zweiten Kühlkörper (13, 14) abzuführen.

## Revendications

1. Appareil électronique de radiodiffusion vidéo numérique (DVB) portable comprenant :
- un boîtier (11) comportant une pluralité de trous d'aération (1131) ;
- une carte de circuit imprimé (12) installée à l'intérieur du boîtier et comportant une puce DVB (121) générant de la chaleur pendant son fonctionnement et une pluralité de composants électroniques pour réaliser des fonctions préétablies ;
- un connecteur d'interface USB (123), exposé hors du boîtier (11) et connecté électriquement à la carte de circuit imprimé (12) ; et
- un premier dissipateur thermique (13), placé à l'intérieur du boîtier (11) et monté étroitement au sommet de la puce DVB (121) afin de dissiper la chaleur dégagée par la puce DVB (121) par les trous d'aération (1131) et d'empêcher la chaleur d'être conduite directement au boîtier.

2. Appareil électronique DVB portable selon la revendication 1, dans lequel le boîtier (11) comprend une coque supérieure (111), une coque inférieure (112) et au moins un panneau latéral (113), le panneau latéral (113) comportant les trous d'aération (1131) et connectant la coque supérieure (111) et la coque inférieure (112).

3. Appareil électronique DVB portable selon la revendication 1, dans lequel le premier dissipateur thermique (13) comprend une pluralité d'ailettes (132) pour dissiper la chaleur.

4. Appareil électronique DVB portable selon la revendication 1, dans lequel le premier dissipateur thermique (13) comprend au moins une découpe (131) s'adaptant aux contraintes de profil de la carte de circuit imprimé (12).

5. Appareil électronique DVB portable selon la revendication 1, comprenant en outre :
- une puce de processeur (124) montée sur la face inférieure de la carte de circuit imprimé (12) et générant de la chaleur ; et
- un deuxième dissipateur thermique (14) connecté à la puce de processeur (124) pour dissiper la chaleur produite par la puce de processeur (124) par les trous d'aération (1131), empêchant ainsi la chaleur d'être conduite directement au boîtier.

6. Appareil électronique DVB portable selon la revendication 5, comprenant en outre un élément thermoconducteur (15) placé entre le premier dissipateur thermique (13) et le deuxième dissipateur thermique (14) pour dissiper la chaleur dégagée par les premier et deuxième dissipateurs thermiques (13, 14).

7. Appareil électronique DVB portable selon la revendication 1, comprenant en outre :
- un deuxième dissipateur thermique (14) situé sous la carte de circuit imprimé ; et
- un élément thermoconducteur (15) placé entre le premier dissipateur thermique (13) et le deuxième dissipateur thermique (14) pour dissiper la chaleur dégagée par les premier et deuxième dissipateurs thermiques (13, 14).
